(19) Europäisches Patentamt / European Patent Office / Office européen des brevets

(11) **EP 2 922 201 B1**

(12) **EUROPÄISCHE PATENTSCHRIFT**

(45) Veröffentlichungstag und Bekanntmachung des Hinweises auf die Patenterteilung:
**10.05.2017 Patentblatt 2017/19**

(51) Int Cl.:
*H03H 7/00* *(2006.01)*   *G02F 1/01* *(2006.01)*
*H01S 3/00* *(2006.01)*   *H03H 9/46* *(2006.01)*
*H03K 5/01* *(2006.01)*   *H04B 10/508* *(2013.01)*

(21) Anmeldenummer: **14161102.0**

(22) Anmeldetag: **21.03.2014**

(54) **Erzeugung beliebiger Pulsformen**

Generation of arbitrary pulse forms

Production d'impulsions de forme arbitraire

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**23.09.2015 Patentblatt 2015/39**

(73) Patentinhaber: **Deutsche Telekom AG**
**53113 Bonn (DE)**

(72) Erfinder: **Schneider, Thomas**
**14552 Michendorf (DE)**

(74) Vertreter: **Braun-Dullaeus Pannen**
**Patent- und Rechtsanwälte**
**Platz der Ideen 2**
**40476 Düsseldorf (DE)**

(56) Entgegenhaltungen:
**JP-A- 2006 293 215**

- **ANDREW M WEINER: "Ultrafast optical pulse shaping: A tutorial review", OPTICS COMMUNICATIONS, NORTH-HOLLAND PUBLISHING CO. AMSTERDAM, NL, Bd. 284, Nr. 15, 30. März 2011 (2011-03-30), Seiten 3669-3692, XP028220993, ISSN: 0030-4018, DOI: 10.1016/J.OPTCOM.2011.03.084 [gefunden am 2011-04-06]**
- **RENE SCHMOGROW ET AL: "Pulse-Shaping With Digital, Electrical, and Optical Filters A Comparison", JOURNAL OF LIGHTWAVE TECHNOLOGY, IEEE SERVICE CENTER, NEW YORK, NY, US, Bd. 31, Nr. 15, 1. August 2013 (2013-08-01), Seiten 2570-2577, XP011518351, ISSN: 0733-8724, DOI: 10.1109/JLT.2013.2271513**
- **M. A. SOTO ET AL.: "Optical sinc-shaped Nyquist pulses of exceptioral quality", NATURE COMMUNICATIONS, Bd. 4, 2013, Seite 7898, XP002727936,**
- **STEFAN PREUSSLER ET AL: "Flat, rectangular frequency comb generation with tunable bandwidth and frequency spacing", OPTICS LETTERS, OPTICAL SOCIETY OF AMERICA, US, Bd. 39, Nr. 6, 15. März 2014 (2014-03-15), Seiten 1637-1640, XP001588054, ISSN: 0146-9592, DOI: 10.1364/OL.39.001637 [gefunden am 2014-03-13]**

EP 2 922 201 B1

**Beschreibung**

Die Erfindung betrifft ein Verfahren zur Erzeugung eines elektromagnetischen Signals mit definierter Pulsform und mit einer maximalen Grenzfrequenz durch Summation von sinc-Pulsen unterschiedlicher Amplitude und definiertem zeitlichen Abstand.

Signale mit definierter Pulsform werden in vielen Bereichen der Wissenschaft und Technik benötigt. Insbesondere in ultra-wideband-Systemen und bei Radarsystemen werden spezielle Pulsformen benötigt, um Signale mit möglichst gutem Signal-zu-Rausch Verhältnis und möglichst geringen Verzerrungen zu übertragen. Bislang werden lineare Verzerrungen auf der Übertragungsstrecke beispielsweise mit Vorverzerrern und Nachverzerrern kompensiert. Neben den genannten Beispielen gibt es eine Vielzahl weiterer Anwendungen für definierte Pulsformen.

Bekanntermaßen lassen sich zur Formung von Signalen geringer Bandbreite Elektrische Arbitrary-Waveform Generatoren (AWGs) einsetzen, wobei die schnellsten elektrischen AWG's mit Abtastraten von bis zu 70 Gbps arbeiten, woraus sich eine analoge Bandbreite von 18 GHz ergibt. Für Pulse größerer Bandbreite respektive für zeitlich kurze Pulse lassen sich AWG's einsetzen, bei denen ein optischer Puls aus dem Zeitbereich in den Frequenzbereich und wieder zurück gewandelt wird, wobei die Amplitude und die Phase jeder einzelnen Frequenzkomponente im Frequenzbereich verändert und damit eine beliebige Pulsform erzeugt wird. Dieser Vorgehensweise bedienen sich kommerziell erhältliche Geräte, wie beispielsweise der WaveShaper der Firma Finisar. Diese Geräte lassen sich allerdings nur für breitbandige Pulse einsetzen, die kürzer als einige wenige Pikosekunden sind. Dabei hat ein 1 ps Puls eine Bandbreite von etwa 1 THz.

Aufgabe der Erfindung ist es nunmehr, ein Verfahren vorzuschlagen, mit dem sich auf technisch einfache und kostengünstige Weise beliebig geformte Pulse mit geringeren Bandbreiten zwischen etwa 18 GHz und 1 THz erzeugen lassen.

Die Aufgabe wird durch ein Verfahren nach Anspruch 1 gelöst. Bevorzugte Ausgestaltungen ergeben sich aus den Unteransprüchen.

Die Grundidee des erfindungsgemäßen Verfahrens zum Erzeugen eines solchen elektromagnetischen Signals definierter Pulsform und maximaler Grenzfrequenz liegt darin, in einem ersten Schritt die zu erzeugende Pulsform dadurch vorzugeben, dass entlang dieser Pulsform eine Mehrzahl von Abtastwerten mit definierten zeitlichen Abständen festgelegt werden. Dann wird ein Frequenzkamm mit einer Anzahl von N äquidistanten Frequenzlinien erzeugt, die jeweils einen Abstand $\Delta$f aufweisen. Ein solcher Frequenzkamm entspricht bekanntermaßen der Fourier-Transformierten einer ersten Folge von sinus cardinalis (sinc)-Pulsen mit gleicher Amplitude und derselben oder einer linear verschobenen Phase.

Die sinc-Pulse dieser ersten Folge von sinc-Pulsen haben zunächst einen ersten zeitlichen Abstand von 1/$\Delta$f, wobei dieser Abstand größer als der definierte zeitliche Abstand der Mehrzahl von Abtastwerten ist. Nachfolgend wird dieser erste zeitliche Abstand 1/$\Delta$f der sinc-Pulse durch Verzögerung auf einen zweiten größeren zeitlichen Abstand von n/(N*$\Delta$f), mit n=1,2,3,... der Abtastwerte vergrößert. Weiterhin wird die Amplitude der einzelnen solchermaßen verzögerten sinc-Pulse an die Höhe des jeweils zugeordneten Abtastwerts angepasst. Zuletzt werden die einzelnen sinc-Pulse dieser verzögerten und in der Amplitude angepassten Folge zu dem zu erzeugenden Puls aufsummiert.

Die Erfindung beruht auf der generellen Überlegung, dass sich nach dem Abtasttheorem jedes beliebige bandbreitenbegrenzte und zeitbegrenzte Signal $s(t)$ mit der maximalen Frequenz $f_g$ durch die Summation zeitlich verschobener sinc-Funktionen darstellen lässt:

$$s(t) = \left[ \sum_{n=-\infty}^{\infty} s(nT)\delta(t - nT) \right] * sinc\left( \pi \frac{t}{T} \right) \tag{1}$$

$$= \sum_{n=-\infty}^{\infty} s(nT) sinc\left( \pi \frac{t - nT}{T} \right)$$

Die Amplitude jeder dieser sinc-Funktionen $s(nT)$ entspricht den mit der Kroneker-Delta Funktion $\delta(t-nT)$ gewonnenen Abtastwerten des zu erzeugenden Pulses die in einem zeitlichen Abstand von höchstens $T=1/(2f_g)$ genommen werden.

Diese Möglichkeit der Erzeugung beliebiger Pulse ist im Prinzip bekannt. Allerdings sind sinc-Pulse der Form

$$\operatorname{sinc}\left(\pi\frac{t}{T}\right) = \frac{\sin\left(\pi\frac{t}{T}\right)}{\pi\frac{t}{T}} \quad (2)$$

nicht-kausal und damit nur ein theoretisches Konstrukt. Es konnte jedoch gezeigt werden, dass die unendliche Summation zeitlich verschobener sinc-Pulse eine periodische sinc-Pulsfolge ergibt (M. A. Soto, et al, "Optical sinc-shaped Nyquist pulses of exceptional quality", Nature Communications 4:7898 doi:10.1033/ncomnms3898 (2013)):

$$\sum_{n=-\infty}^{\infty} \operatorname{sinc}\left(\frac{\pi}{T} - nT_p\right) = \frac{\sin\left(\pi\frac{t}{T}\right)}{N\sin\left(\pi\frac{t}{T}\right)} \quad (3)$$

Dabei entspricht $T_p=1/\Delta f$ der Periodendauer der Pulsfolge.

Obwohl jeder einzelne sinc-Puls zeitlich unendlich ausgedehnt ist, können die Pulse summiert werden, ohne dass es zwischen ihnen zu einer Interferenz kommt. Dies resultiert aus der Zero-Intersymbol Interference, die alle Nyquist-Pulse, mithin auch die sinc-Pulse, auszeichnet (s. "Sotho et al).

Auch wenn sich in der Praxis keine einzelnen sinc-Pulse entsprechend Gleichung (2) erzeugen lassen, so kann dennoch eine sinc-Pulsfoige nach Gleichung (3) generiert werden. Schließlich entspricht die rechte Seite der Gleichung (3) der Fourier-Transformierten eines Frequenzkamms, der N äquidistante Frequenzlinien mit einem jeweiligen Frequenzabstand von $\Delta f$ aufweist. Entsprechend der Erfindung wird daher ein solcher Frequenzkamm erzeugt.

Besonders vorteilhaft ist, dass sich zur technischen Umsetzung der Erfindung gebräuchliche und kostengünstige Komponenten wie Koppler, Splitter, Modulatoren und Glasfasern unterschiedlicher Länge einsetzen lassen. Dies sind alles Standardelemente der optischen Nachrichtentechnik und damit preiswert verfügbar. Eine andere Möglichkeit ist die Integration auf der Basis eines Glassubstrats oder der Silicon-on-Insulator Technologie. Die benötigten Funktionsblöcke (Koppler, Splitter, Wellenleiter, Modulator) sind auch hier Standardelemente der Integration.

An Stelle von Kopplern, Splittern und Wellenleitern lassen sich micro-electro-mechanical-systems (MEMS) verwenden. Die Verzögerung der Pulse kann dann durch unterschiedlich lange Wege im Freiraum erfolgen. Zur Veränderung der einzelnen Amplituden lassen sich beispielsweise spatial-light-modulatoren nutzen. Die Verwendung von MEMS hat den Vorteil, dass sich eine Vielzahl von Pfaden gleichzeitig realisieren lassen.

Mit der erfindungsgemäßen Vorgehensweise besteht nun die Möglichkeit, Pulse mit kleiner Bandbreite zwischen 18 GHz und 1 THz beliebiger Form zu generieren. Nunmehr können neben besonders schmalbandigen und besonders breitbandigen Pulsen auch beliebige Pulse für den genannten Bandbreitenbereich erzeugen werden. Dieser Frequenzbereich ist für die so genannte Mikrowellenphotonik, für Radaranwendungen und für die THz-Kommunikation besonders interessant.

Die Erfindung wird anhand der Figuren nachfolgend näher erläutert. Es zeigen:

**Figur 1** eine Intensitätsverteilung einer sinc-Pulsfolge,

**Figur 2** einen schematischen Aufbau eines Pulsformgenerators und

**Figur 3** Beispiele erzeugter Pulsformen.

Erfindungsgemäß wird zunächst ein Frequenzkamm erzeugt, in dem alle Linien dieselbe Amplitude und dieselbe respektive eine linear unterschiedliche Phase haben. Wenn sinc-Pulse längerer Dauer erzeugt werden sollen, kann ein solcher Frequenzkamm mit einem Mach-Zender Modulator (MZM), der mit mehreren RF-Frequenzen angetrieben wird, oder mit gekoppelten MZM erzeugt werden.

Wenn eine Folge besonders kurzer sinc-Pulse erzeugt werden soll, ist es vorteilhaft, aus einem modengekoppelten Laser, einen ersten Frequenzkamm mit einer größeren Anzahl von Linien mit äquidistantem Abstand zu extrahieren. Diese Linien dienen dann als Eingangslinien für einen oder mehrere kaskadierte Modulatoren. Durch die Modulation werden wiederum neue Seitenbänder erzeugt, wobei die Anzahl der extrahierten Linien und damit die Breite des Kamms frei wählbar sind.

Der Frequenzabstand ist durch die Modulation veränderbar. Es ist jedoch darauf zu achten, dass der Frequenzabstand zwischen den Linien über die Modulation gleich eingestellt wird. Insofern hängt der wählbare Frequenzabstand auch vom Abstand der ursprünglich extrahierten Linien ab. Die Bandbreite des solchermaßen erzeugten Frequenzkamms ist damit durch die Bandbreite des ersten Frequenzkamms vorgegeben und kann im THz-Bereich liegen. Gleichzeitig ermöglicht das Filtern eine Anpassung der Amplituden der einzelnen Frequenzen.

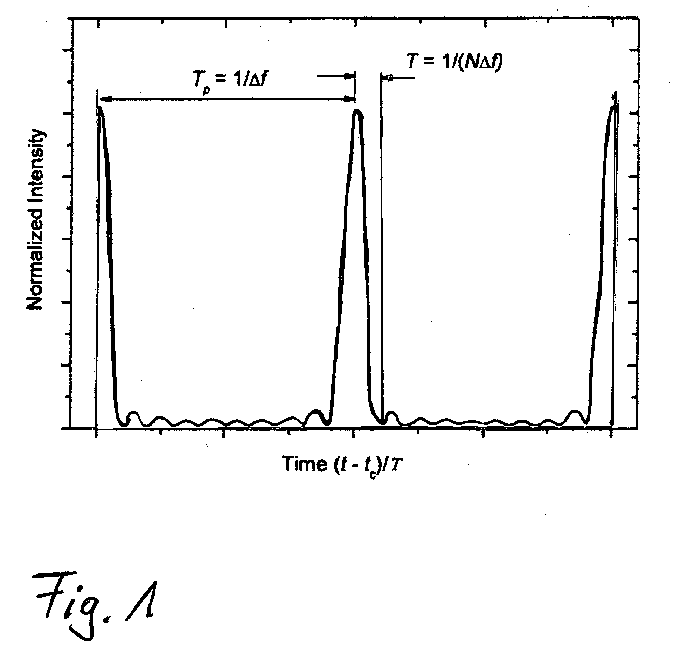

In Figur 1 ist eine solche Folge von Pulsen eines Abstandes $\Delta f$ und einer bestimmten Amplitude gezeigt, die aus einem ursprünglich vorhandenen Frequenzkamm mit N= 9 Frequenzen erzeugt ist. Wenn eine solche Pulsfolge mit einem optischen Messgerät aufgenommen wird, lässt sich lediglich die Intensität und nicht das Feld selbst messen. Daher zeigt Figur 1 die Intensitätsverteilung der Pulsfolge, die proportional zum Quadrat des Feldes ist.

Derartige Pulsfolgen werden nun entsprechend Gleichung (1) erfindungsgemäß zeitlich verzögert. Andererseits werden die Amplituden der Pulse entsprechend der vorher definierten Abtastwerte verändert. Zuletzt werden die solchermaßen veränderten Pulsfolgen wieder aufsummiert. Da es sich jedoch um sinc-Pulsfolgen und nicht um einzelne sinc-Pulse handelt, werden keine einzelnen Pulse, sondern Pulsfolgen erzeugt. Das ist jedoch keine Einschränkung, sondern bei allen arbitrary-waveform Generatoren der Fall.

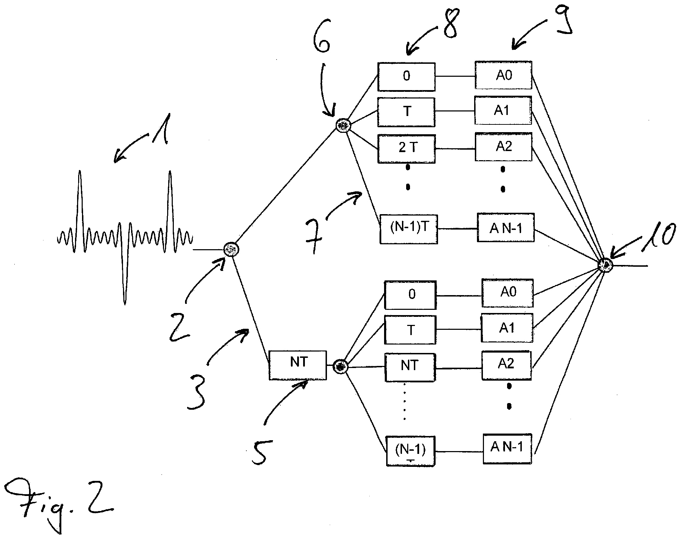

Figur 2 zeigt schematisch einen möglichen Aufbau eines Pulsformgenerators:

Erfindungsgemäß werden zunächst eine Mehrzahl von Abtastwerten mit definiertem zeitlichen Abständen entlang der zu erzeugenden Pulsform vorgegeben. Die Vorgabe dieser Abtastwerte kann beispielsweise durch ein Simulationsprogramm erfolgen, mit dem die Pulsform angenähert wird. Der zeitliche Abstand T entspricht der Verschiebung der einzelnen sinc-Funktionen.

Dann wird ein optischer Frequenzkamm mit einer geraden Anzahl $N$ von äquidistanten Linien mit einem Abstand $\Delta f$ erzeugt, welcher der Fourier-Transformierten einer ersten Folge von sinc-Pulsen gleicher Amplitude und derselben oder linear unterschiedlicher Phase entspricht. Dabei haben die sinc-Pulse einen ersten zeitlichen Abstand von $1/\Delta f$, der größer als der definierte zeitliche Abstand ist.

Durch die geradzahlige Anzahl der Linien im Frequenzkamm sind im vorliegenden Beispiel zwei aufeinanderfolgende Pulse zueinander gegenphasig. Die so erzeugte Pulsfolge 1 wird insbesondere mittels eines 3dB-Splitters 2 auf zwei Wege 3 und 4 (Blöcke) aufgeteilt. Der in der Figur 2 unten dargestellte Pfad 3 wird gegenüber dem oberen Pfad 4 durch das Verzögerungsmittel 5, insbesondere einem Wellenleiter geeigneter Länge, um die Zeit $NT$ verzögert. Somit steht im unteren Pfad 3 ein Puls und im oberen Pfad 4 der um $\pi$ verschobene Puls zu derselben Zeit zur Verfügung. Dementsprechend können im unteren Pfad 3 positive und im oberen Pfad 4 negative Amplitudenwerte entsprechend der Gleichung (1) eingestellt werden.

Anschließend wird die jeweilige Pulsfolge sowohl im oberen Pfad 4 als auch im unteren Pfad 3 mit jeweils einem 1: N Splitter 6 in jeweils NT Einzelpfade 7 aufgeteilt. In jedem der Einzelpfade 7 wird dann mittels eines weiteren Verzögerungsgliedes 8 gemäß der Gleichung (1) eine Verzögerung des jeweiligen Pulses um $nT$ mit n = 0, 1, 2 ... N-1 eingestellt. Damit wird der erste zeitliche Abstand $1/\Delta f$ der sinc-Pulse durch Verzögerung auf den zeitlichen Abstand $n/(N^*\Delta f)$, mit n=1,2,3,... der zu Beginn definierten Abtastwerte vergrößert.

Darauffolgend wird jeweils mit einem Modulator oder einem anderen geeigneten Element 9 eine Veränderung der Amplitude $A_0$... $A_{N-1}$ des jeweiligen Pulses in jedem Einzelpfad 7 vorgenommen. Damit wird die Amplitude des einzelnen sinc-Pulses an die Höhe des jeweils zugeordneten Abtastwerts angepasst. Wenn es sich bei der Amplitude $A_n$ um eine positive Amplitude handelt, wird diese im unteren Block eingestellt. In diesem Fall ist $A_n$ im oberen Block Null. Handelt es sich hingegen um eine negative Amplitude, so wird diese im oberen Block eingestellt, während $A_n$ im unteren Block Null ist.

Zuletzt werden die verzögerten und in ihrer Amplitude veränderten Pulsfolgen mit Hilfe eines 2N:1 10 Kopplers zu dem zu erzeugenden Puls aufsummiert, so dass am Ende die beliebige Pulsfolge im optischen Bereich zur Verfügung steht, die dann durch Photodioden geeigneter Bandbreite in den Mikro-Millimeterwellen- oder Terahertz-Bereich des elektromagnetischen Spektrums gewandelt werden kann.

Im Aufbau nach Figur 2 entspricht die Verzögerung der einzelnen Pfade in den Einzelpfaden $T = 1/(2f_g) = 1/(N\Delta f)$, also der Zeit vom Maximum des Pulses bis zur ersten Nullstelle (siehe Figur 2). Allgemein reicht es aus, wenn die Verzögerung der Pfade ein Vielfaches von $T$, also $nT$ ist. Weiterhin entspricht die Anzahl der Einzelpfade in jedem Block des Beispielaufbaus der Anzahl der Frequenzen im Kamm der sinc-Pulsfolge bzw. der Anzahl ihrer Nullstellen zwischen zwei Maxima $N$. In einem allgemeinen Aufbau kann die Anzahl der Pfade größer oder kleiner als $N$ gewählt werden.

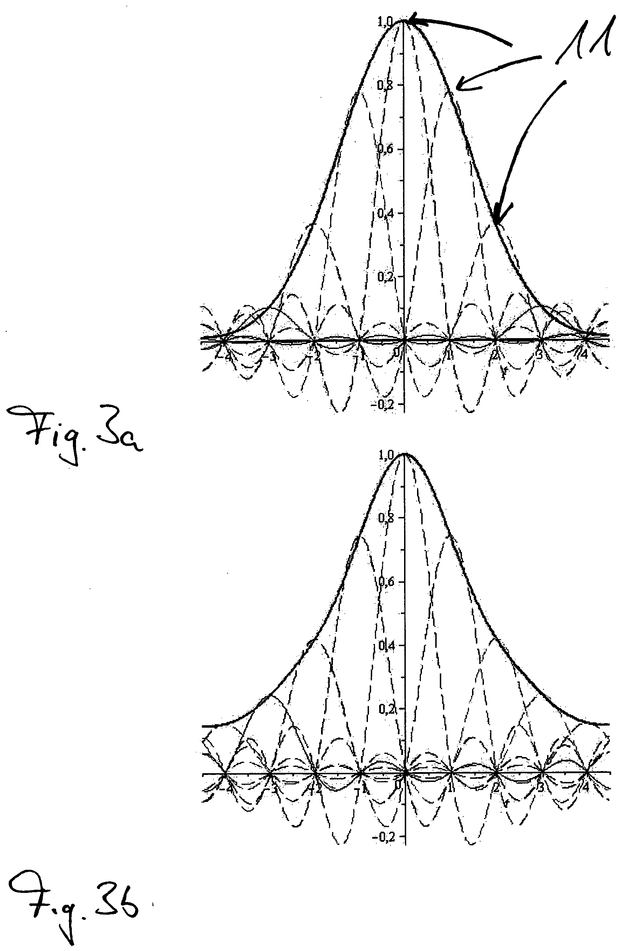

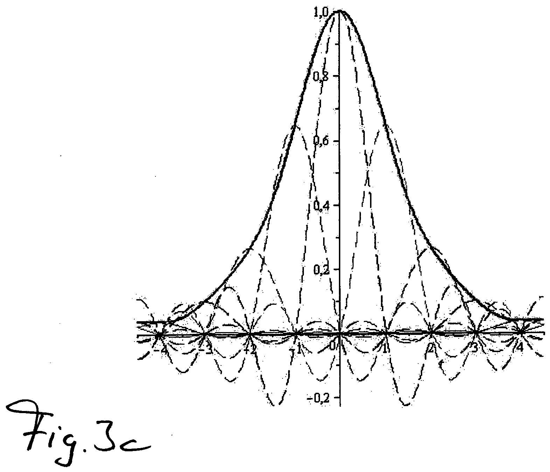

Figur 3 zeigt beispielhaft die Summation von neun sinc-Funktionen (gestrichelte Linien) mit unterschiedlichen Amplituden $s(nT)$ für die Erzeugung eines Gauss-Pulses (a), eines Lorentz-Pulses (b) und eines sech-Pulses, respektive eines Solitons (c), wobei die durchgezogene Linien die aufsummierte sinc-Funktion darstellen. Um diese Pulse zu erzeugen, würden in diesem Fall im ersten Schritt neun gleich beabstandete Abtastwerte 11 bei unterschiedlicher Amplitude beispielsweise durch rechnerische Simulation der Pulsform definiert.

## Patentansprüche

1. Verfahren zum Erzeugen eines elektromagnetischen Signals s (t) definierter Pulsform und einer maximalen Grenzfrequenz ($f_{grenz}$) durch Summation von sinc-Pulsen mit unterschiedlicher Amplitude und definiertem zeitlichen Abstand,
wobei in dem definierten zeitlichen Abstand Abtastwerte entlang der Pulsform festgelegt werden,
wobei ein Frequenzkamm mit einer Anzahl von N äquidistanten Frequenzlinien mit einem Abstand $\Delta f$ erzeugt wird, welcher der Fourier-Transformierten einer ersten Folge von sinc-Pulsen gleicher Amplitude und derselben oder linear unterschiedlicher Phase entspricht, wobei diese sinc-Pulse einen ersten zeitlichen Abstand von $1/\Delta f$ haben, der größer als der definierte zeitliche Abstand ist,
wobei der erste zeitliche Abstand $1/\Delta f$ der sinc-Pulse durch Verzögerung auf den zeitlichen Abstand $n/(N*\Delta f)$, mit n=1,2,3,... der Abtastwerte vergrößert wird,
wobei die Amplitude der einzelnen sinc-Pulse an die Höhe des jeweils zugeordneten Abtastwerts angepasst wird und wobei die einzelnen sinc-Pulse zu dem zu erzeugenden Puls aufsummiert werden.

2. Verfahren nach Anspruch 1,
**dadurch gekennzeichnet,**
**dass** ein optischer Frequenzkamm mit einer geraden Anzahl von N Linien mit insbesondere folgenden Verfahrensschritten erzeugt wird, wobei die gerade Anzahl von N Linien zu gegenphasigen sinc-Pulsen führt:

- Erzeugen eines Eingangsfrequenzkamms mit einem modengelockten Laser, wobei der Eingangsfrequenzkamm eine Vielzahl von Eingangsfrequenzkammlinien aufweist.
- Herausfiltern einzelner Frequenzkammlinien mit identischem Frequenzabstand aus dem Eingangsfrequenzkamm.
- Modulation der gefilterten Frequenzkammlinien zur Erzeugung von Seitenbandlinien, wobei die Seitenbandlinien durch die Modulation derart eingestellt werden, dass Frequenzkammlinien und Seitenbandlinien einen identischen Frequenzabstand zueinander aufweisen.

3. Verfahren nach Anspruch 1 oder 2,
**dadurch gekennzeichnet,**
**dass** Abtastwerte in einem zeitlichen Abstand T von höchstens $1/(2*f_{grenz})$ insbesondere durch eine rechnerische Simulation des zu erzeugenden Pulses erzeugt werden.

4. Verfahren nach einem der vorherigen Ansprüche,
**dadurch gekennzeichnet,**
**dass** die erste Folge von sinc-Pulsen insbesondere mittels eines 3dB Splitters auf zwei Wege aufgeteilt wird, wobei die Pulse des einen Pfades um N*T gegenüber den Pulsen des anderen Pfades verzögert werden.

5. Verfahren nach Anspruch 4,
**dadurch gekennzeichnet,**
**dass** die Verzögerung durch Wellenleiter entsprechender Länge hervorgerufen wird.

6. Verfahren nach Anspruch 4,
**dadurch gekennzeichnet,**
**dass** jede der beiden auf die Wege aufgeteilten Pulsfolgen mittels eines 1:N Splitters in die einzelnen Pulse aufgeteilt werden und jeder Puls um nT verzögert wird, wobei gilt n = 0, 1, 2, ... N-1.

7. Verfahren nach Anspruch 6,
**dadurch gekennzeichnet,**
**dass** die Amplitude jedes Pulses insbesondere mittels eines Modulators entsprechend des Abtastwertes eingestellt wird.

8. Verfahren nach Anspruch 7,

**dadurch gekennzeichnet,**
**dass** die verzögerten und in ihrer Amplitude veränderten Pulsfolgen insbesondere mittels eines N:1 Kopplers aufsummiert werden.

9. Verfahren nach Anspruch 8,
**dadurch gekennzeichnet,**
**dass** das aus den aufsummierten Pulsfolgen generierte optische Signal insbesondere durch eine Photodiode geeigneter Bandbreite gewandelt wird.

**Claims**

1. A method for generating an electromagnetic signal s(t) having a defined pulse shape and a maximum limiting frequency ($f_{grenz}$), by summation of sinc-pulses with different amplitude and defined temporal interval,
   wherein sample values are specified along the pulse shape in the defined temporal interval,
   wherein a frequency comb with a number N of equidistant frequency lines having a spacing $\Delta f$ is generated, which corresponds to the Fourier transform of a first sequence of sinc-pulses of constant amplitude and with the same or linearly different phase, wherein these sinc-pulses have a first temporal interval of $1/\Delta f$, which is greater than the defined temporal interval,
   wherein the first temporal interval $1/\Delta f$ of the sinc-pulses is increased by delaying up to the temporal interval $n/(N*\Delta f)$, with n = 1, 2, 3, ... of the sample values,
   wherein the amplitude of the individual sinc-pulses is adapted to match the amplitude of the respectively assigned sample value, and
   wherein the individual sinc-pulses are summed up to form the pulse to be generated.

2. The method according to claim 1,
   **characterized in**
   **that** an optical frequency comb having an even number of lines N is generated, in particular with the following method steps, wherein the even number of lines N leads to anti-phase sinc-pulses:

   - Generating an input frequency comb with a mode-locked laser, wherein the input frequency comb comprises a plurality of input frequency comb lines,
   - Filtering individual frequency comb lines having identical frequency interval out of the input frequency comb,
   - Modulation of the filtered frequency comb lines to generate sideband lines, wherein the sideband lines are adjusted by the modulation in such a way that frequency comb lines and sideband lines have an identical frequency interval relative to one another.

3. The method according to claim 1 or 2,
   **characterized in**
   **that** sample values are generated in a temporal interval T which is not exceeding $1/(2*f_{grenz})$, in particular by a computational simulation of the pulse to be generated.

4. The method according to any one of the previous claims,
   **characterized in**
   **that** the first sequence of sinc-pulses is split onto two paths, in particular by means of a 3dB splitter, wherein the pulses of the first path are delayed by N*T with respect to the pulses of the other path.

5. The method according to claim 4,
   **characterized in**
   **that** the delay is induced by waveguides of appropriate length.

6. The method according to claim 4,
   **characterized in**
   **that** each of the two pulse sequences that are split onto the paths is split into the individual pulses by means of a 1:N splitter and each pulse is delayed by nT, wherein n = 0, 1, 2, ... N-1.

7. The method according to claim 6,
   **characterized in**

**that** the amplitude of each pulse is adjusted, in particular by means of a modulator, according to the sample value.

8. The method according to claim 7,
**characterized in**
**that** the pulse sequences, which are delayed and modified in amplitude, are summed up, in particular by means of an N:1 coupler.

9. The method according to claim 8,
**characterized in**
**that** the optical signal generated from the summed pulse sequences is transformed, in particular by means of a photodiode of suitable bandwidth.

**Revendications**

1. Procédé pour produire un signal électromagnétique s(t) de forme d'impulsion définie et d'une fréquence limite maximale ($f_{lim}$) par addition des impulsions sinc avec amplitude différente et intervalle de temps défini, des valeurs d'exploration étant définies le long de la forme d'impulsion dans l'intervalle de temps défini, un peigne de fréquence avec un nombre N lignes de fréquence équidistantes étant produit avec un intervalle $\Delta f$, lequel correspond à la transformée de Fourier d'une première suite d'impulsions sinc d'amplitude identique et à la même phase ou linéairement différente, ces impulsions sinc ayant un premier intervalle de temps de $1/\Delta f$, qui est plus important que l'intervalle de temps défini, le premier intervalle de temps $1/\Delta f$ des impulsions sinc étant amplifié avec n = 1, 2, 3 ... des valeurs d'exploration par temporisation sur l'intervalle de temps $n/(N*\Delta f)$, l'amplitude de chaque impulsion sinc étant adaptée à l'importance de la valeur d'exploration respectivement attribuée et chaque impulsion sinc étant additionnée à l'impulsion à générer.

2. Procédé selon la revendication 1,
**caractérisé en ce**
**qu'**un peigne de fréquence optique est généré avec un nombre pair de N lignes notamment avec les étapes de procédé suivantes, le nombre pair de N lignes conduisant à des impulsions sinc en opposition de phase :

- production d'un peigne de fréquence d'entrée avec un laser à verrouillage de mode, le peigne de fréquence d'entrée comportent une pluralité de lignes de peigne de fréquence d'entrée,
- filtrage des lignes de peigne de fréquence individuelles avec intervalle de fréquence identique à partir du peigne de fréquence d'entrée,
- modulation des lignes de peigne de fréquence filtrées pour générer des lignes de bande latérale, les lignes de bande latérale étant ajustées par la modulation de telle manière que les lignes de peigne de fréquence et les lignes de bande latérale comportant un intervalle de fréquence identique les unes par rapport aux autres.

3. Procédé selon la revendication 1 ou 2,
**caractérisé en ce**
**que** les valeurs d'exploration sont générées dans un intervalle de temps T d'un maximum de $1/(2*f_{lim})$, notamment par simulation mathématique de l'impulsion à générer.

4. Procédé selon l'une quelconque des revendications précédentes,
**caractérisé en ce**
**que** la première suite d'impulsions sinc est répartie sur deux trajectoires, notamment au moyen d'un séparateur à 3dB, les impulsions d'un trajet étant temporisées de N*T par rapport aux impulsions de l'autre trajet.

5. Procédé selon la revendication 4,
**caractérisé en ce**
**que** la temporisation est causée par des guides d'ondes de longueur correspondante.

6. Procédé selon la revendication 4,
**caractérisé en ce**
**que** les deux suites d'impulsions réparties sur les trajectoires sont chacune réparties dans les impulsions individuelles au moyen d'un séparateur 1:N et chaque impulsion est temporisée de nT, en appliquant n = 0, 1, 2 ... N-1.

7. Procédé selon la revendication 6,
   **caractérisé en ce**
   **que** l'amplitude de chaque impulsion est ajustée en particulier au moyen d'un modulateur selon la valeur d'exploration.

8. Procédé selon la revendication 7,
   **caractérisé en ce**
   **que** les suites d'impulsions temporisées et modifiées dans leur amplitude sont totalisées notamment au moyen d'un coupleur N:1.

9. Procédé selon la revendication 8,
   **caractérisé en ce**
   **que** le signal optique généré à partir des suites d'impulsions totalisées est converti notamment par une photodiode de largeur de bande appropriée.

Fig. 1

Fig. 2

Fig. 3a

Fig. 3b

Fig.3c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **M. A. SOTO et al.** Optical sinc-shaped Nyquist pulses of exceptional quality. *Nature Communications,* 2013, vol. 4, 7898